# EUROPÄISCHE PATENTANMELDUNG

(11) **EP 1 951 020 A1**
(43) Veröffentlichungstag der Anmeldung: **30.07.2008**
(21) Anmeldenummer: 07001753.8
(22) Anmeldetag: 26.01.2007
(51) Int. Cl.: H05K 7/20

(54) **Gehäuse zur Aufnahme von elektrischen oder elektronischen Geräten**

(71) Anmelder: ISL media Singapore PTE LTD, Singapore 059413 (SG)
(72) Erfinder: Wellhöfer, Stefan, 99195 Schlossvippach (DE)
(74) Vertreter: Wächter, Jochen

(57) **Zusammenfassung**

Das Gehäuse (2) weist zwei in sich geschlossene Gehäuseabschnitte (3, 5) auf, von denen jeder eine Kammer (7, 9) definiert, die zur Aufnahme von elektrischen oder elektronischen Geräten (11, 13) geeignet ist, wobei die Gehäuseabschnitte (3, 5) beabstandet zueinander angeordnet sind, sodass zwischen einer Wandfläche (8) des ersten Gehäuseabschnittes (3) und einer gegenüberliegenden Wandfläche (10) des zweiten Gehäuseabschnittes (5) ein Lüftungskanal (15) definiert wird, der über mindestens eine Eintrittsöffnung (17) zur Zuführung kühler Luft sowie mindestens eine Austrittsöffnung (19) zur Abgabe erwärmter Luft mit der Umgebung verbunden ist, wobei mindestens eine der den Lüftungskanal (15) definierenden Wandflächen (8, 10) einen Kühlkörper (21, 23) aus Wärme leitendem Material aufweist.

## Beschreibung

Die Erfindung betrifft ein Gehäuse zur Aufnahme von elektrischen oder elektronischen Geräten im Allgemeinen, und insbesondere ein Gehäusesystem für großflächige elektrische oder elektronische Baugruppen, das im Außenbereich eingesetzt werden kann.

Durch die technische Entwicklung ist es heute möglich, großflächige Anzeigeeinrichtungen zur Darstellung von bewegten Bildern auf der Basis von Flachbildschirmen, zum Beispiel mittels LCD-Technik, einzusetzen. Möglich ist der Einsatz von großflächigen Monitorsystemen im Außenbereich u.a. als Werbeträger oder als Informationssysteme im öffentlichen Bereich, zum Beispiel auf Flughäfen, Bahnhöfen und dergleichen. Die für einen derartigen Einsatz gewünschte Größe von Flachbildschirmeinrichtungen beträgt üblicherweise bis zu 80 Zoll (etwa 2 Meter) in der Bildschirmdiagonalen. Mit Hilfe neuer Technologien der Hintergrundbeleuchtung kann die Helligkeit der Anzeigen wesentlich erhöht werden, wodurch derartige Systeme auch tageslichttauglich sind.

Für den Einsatz im Außenbereich sind die Anforderungen besonders hoch. Zum einen müssen die Monitorsysteme an die klimatischen Bedingungen angepasst sein, d.h. sie müssen in einem Temperaturbereich von - 35°C bis etwa + 40°C einwandfrei arbeiten, ohne dass die elektrischen oder elektronischen Geräte Schaden nehmen. Weiterhin sollten sämtliche elektrischen und elektronischen Bauelemente vor Staub und Feuchtigkeit geschützt sein. Als weitere Anforderung gilt, dass das Monitorsystem durch die Aufstellung oder die Anbringung in öffentlichen Räumen oder Plätzen eine robuste und vandalismussichere Bauweise aufweisen muss. Außerdem soll eine flexible und sichere Befestigung von allen Seiten möglich sein und bei Ausfall einer elektrischen oder elektronischen Baugruppe diese schnell und problemlos ausgetauscht werden können.

Nach heutigem Stand der Technik werden für derartige Gehäusesysteme im Außenbereich aktive Kühl- oder Heizsysteme, die es in einer Vielzahl von Technologien gibt, verwendet. Diese aktiven Kühl- oder Heizsysteme werden üblicherweise außen am Gehäuse befestigt und kühlen bzw. erwärmen den Teil des Gehäuses, an dem sie befestigt sind. Problematisch an derartigen aktiven Kühl- oder Heizsystemen ist, dass die Kühlflächen für den Wärmeaustausch vor Sonneneinstrahlung geschützt werden müssen. Aus diesem Grund sind sie für eine flexible Verwendung im Außenbereich nicht geeignet.

Des Weiteren haben sich Standardwärmetauscher, die nach dem Prinzip Luft/Luft funktionieren, aufgrund der unflexiblen konstruktiven Ausführung der Kühlfläche als nicht geeignet erwiesen.

Es ist daher die Aufgabe der vorliegenden Erfindung, ein Gehäuse zur Aufnahme von elektrischen oder elektronischen Geräten bereitzustellen, das im Außenbereich einsetzbar ist, relativ einfach aufgebaut ist, eine hervorragende Abfuhr der von den elektrischen Geräten erzeugten Wärme liefert und auch unter extremen Bedingungen eine lange Lebensdauer der aufgenommenen elektrischen Geräte fördert.

Diese Aufgabe wird durch die Merkmale des Anspruchs 1 gelöst.

Erfindungsgemäß ist ein Gehäuse mit zwei in sich geschlossenen Gehäuseabschnitten vorgesehen, von denen jeder eine Kammer definiert, die zur Aufnahme von elektrischen oder elektronischen Geräten geeignet ist, wobei die Gehäuseabschnitte beabstandet zueinander angeordnet sind, sodass zwischen einer Wandfläche des ersten Gehäuseabschnitts und einer gegenüberliegenden Wandfläche des zweiten Gehäuseabschnitts ein Lüftungskanal definiert wird, der über mindestens eine Eintrittsöffnung zur Zuführung kühler Luft sowie mindestens eine Austrittsöffnung zur Abgabe erwärmter Luft mit der Umgebung verbunden ist, wobei mindestens eine der den Lüftungskanal definierenden Wandflächen einen Kühlkörper aus Wärme leitendem Material aufweist. Durch die geschlossenen Gehäuseabschnitte ist gewährleistet, dass weder Staub noch Feuchtigkeit zu den elektrischen oder elektronischen Geräten vordringen kann.

Vorteilhafterweise ist in beiden Wandflächen jeweils mindestens ein Kühlkörper angeordnet. Damit ist je nach Positionierung der elektrischen oder elektronischen Geräte eine Dimensionierung der Kühlkörper möglich, die somit nur einen kleinen Teil der Wandfläche oder auch die gesamte Wandfläche einnehmen können.

Mit besonderem Vorteil ist in der ersten und/oder zweiten Kammer ein Lüfter angeordnet, der geeignet ist, einen zirkulierenden Luftstrom innerhalb der Kammer zu erzeugen. Ein zirkulierender Luftstrom sorgt für eine gleichmäßige Abfuhr der entstehenden Wärme oder für eine gleichmäßige Zufuhr von Wärme, sodass eine optimierte Kühl- bzw. Heizwirkung erzielt wird.

Vorteilhafterweise ist in dem Lüftungskanal mindestens ein Lüfter angeordnet, der geeignet ist, einen Luftstrom von der Eintrittsöffnung in Richtung der Austrittsöffnung zu lenken. Durch die Anordnung eines Lüfters im Lüftungskanal ist gewährleistet, dass das Gehäuse in einer beliebigen räumlichen Anordnung positioniert werden kann, d.h. eine Strömungsrichtung von kalter Luft von unten nach oben ist nicht zwingend vorgeschrieben.

Vorzugsweise ist der oder jeder Lüfter als Walzenlüfter ausgebildet. Der Walzenlüfter sorgt dafür, dass eine große Fläche mit einem einzigen Lüfter gleichmäßig beströmt werden kann.

Mit besonderem Vorteil ist der oder jeder Lüfter temperaturgeregelt. Mit einer an sich bekannten Temperaturregelung des Lüfters ist gewährleistet, dass der Lüfter bei geringer erforderlicher Kühlleistung weniger Leistung verbraucht und damit Strom spart.

In bevorzugter Weise weist der oder jeder Kühlkörper eine Mehrzahl von Kühlrippen auf, die in Richtung des jeweiligen Luftstroms geneigt sind. Durch die zusätzliche Kühlfläche der Kühlrippen wird die Wärmeaufnahmefläche des Kühlkörpers und damit die Kühlleistung erhöht. Darüber hinaus sorgt die Form der Kühlrippen dafür, dass eine gewisse Verwirbelung der Luftströme, die am Kühlkörper entlang geführt werden, zu einer größeren Kühlwirkung beiträgt, ohne den Luftstrom übermäßig zu bremsen.

Vorteilhafterweise ist der oder jeder Kühlkörper als Formteil aus einer gepressten Aluminiumlegierung ausgebildet. Aluminium ist aufgrund seiner hohen Wärmeleitfähigkeit als Material für den Kühlkörper ideal geeignet. Selbstverständlich ist es jedoch möglich, auch andere Wärme leitende Materialien anstelle von Aluminium zu verwenden. Darüber hinaus ist es ebenfalls möglich, gegossene oder auf andere Art und Weise geformte Aluminiumteile zu verwenden.

Mit besonderem Vorteil ist in der ersten Kammer eine Platte schräg zur Wandfläche, die den Kühlkörper aufweist, angeordnet, sodass zwischen der Platte und der Wandfläche ein sich in Richtung des Luftstroms verjüngender Kammerabschnitt definiert wird. Mit dieser Platte können die Strömungsverhältnisse der entstehenden Warmluft in besonderer Weise gesteuert werden. Durch die besondere Anordnung mit dem sich verjüngenden Kammerabschnitt erhöht sich die Strömungsgeschwindigkeit durch den Venturi-Effekt.

Vorteilhafterweise ist mindestens eine der Außenflächen des Gehäuses als durchsichtige Platte ausgebildet. Damit können in den Gehäuseabschnitten Anzeigevorrichtungen wie zum Beispiel Flachbildschirme (LCD, Plasma, TFT etc.) angeordnet sein. Die durchsichtige Platte selbst kann aus jedem beliebigen durchsichtigen Material sein, wie z.B. Glas, Plexiglas oder dergleichen.

Erfindungsgemäß wird auch ein Monitorsystem für den Outdoor-Bereich bereitgestellt, wobei das Monitorsystem neben dem oben beschriebenen Gehäuse in der ersten Kammer einen Flachbildschirm sowie in der zweiten Kammer eine Steuereinheit aufweist. Die Steuereinheit kann als handelsüblicher PC ausgebildet sein. Die Technologie des Flachbildschirms kann dabei frei gewählt werden, z.B. LCD, OLED oder Plasma.

Mit besonderem Vorteil ist der Flachbildschirm in der ersten Kammer derart angeordnet, dass zu beiden Seiten des Flachbildschirms jeweils ein Hohlraum ausgebildet ist. Durch diese Hohlräume strömt der zirkulierende Luftstrom und sorgt somit für eine Wärmeabfuhr des Flachbildschirms.

Bevorzugter Weise ist in der zweiten Kammer des Monitorsystems für den Outdoor-Bereich ein Computer mit integriertem Lüfter angeordnet, der eine Luftzirkulation in der zweiten Kammer hervorruft. Der Computer kann dabei ein handelsüblicher PC mit Standardgehäuse sein, in dem ein eigener Lüfter für die Zirkulation der Luft sorgt. Das Gehäuse des Computers kann dabei mit geeigneten Lüftungsschlitzen oder -löchern ausgebildet sein, die für eine Zirkulation des Luftstroms in der gesamten Kammer sorgen.

Weitere Einzelheiten, Merkmale und Vorteile der vorliegenden Erfindung ergeben sich aus der nachfolgenden Beschreibung unter Bezugnahme auf die Zeichnung.

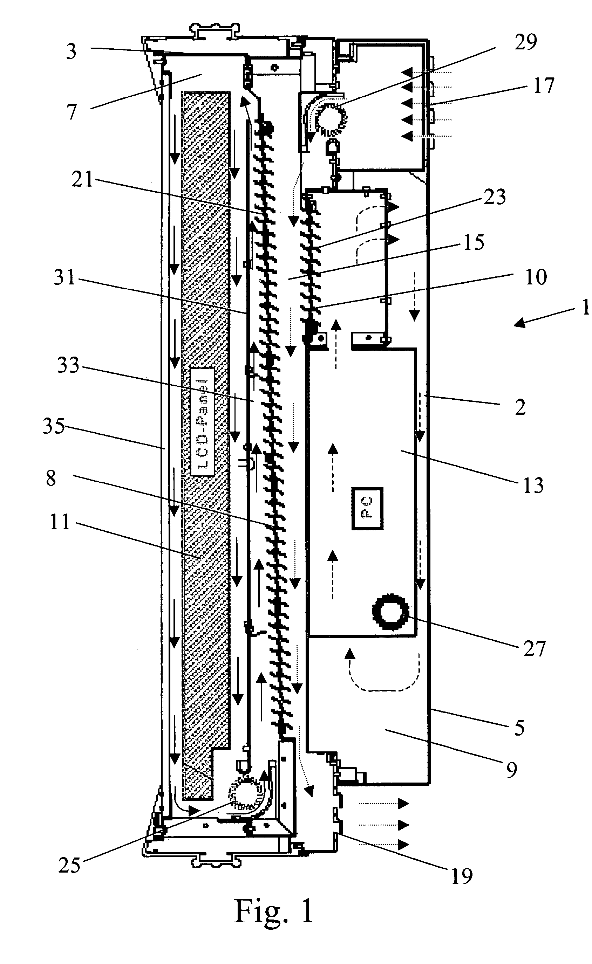

Fig. 1 ist eine Querschnittsansicht einer bevorzugten Ausführungsform eines Monitorsystems mit dem erfindungsgemäßen Gehäuse.

In Fig. 1 ist eine bevorzugte Ausführungsform der vorliegenden Erfindung in Querschnittsansicht dargestellt. Das Monitorsystem 1 umfasst ein Gehäuse 2, das einen ersten in sich geschlossenen Gehäuseabschnitt 3 sowie einen zweiten in sich geschlossenen Gehäuseabschnitt 5 aufweist. Diese beiden staubdicht und im Wesentlichen wasserdicht ausgebildeten Gehäuseabschnitte 3 und 5 definieren jeweils eine Kammer 7 bzw. 9. Die Kammer 7 umfasst in ihrem Inneren ein LCD-Panel 11, das mittels geeigneter Befestigungsmittel ortsfest in der Kammer 7 angeordnet ist. In der zweiten Kammer 9, die durch den zweiten in sich geschlossenen Gehäuseabschnitt 5 definiert ist, ist ein handelsüblicher PC mit eigenem Gehäuse angeordnet, der als Steuereinheit 13 des Monitorsystems 1 dient.

Die beiden Gehäuseabschnitte 3 und 5 sind derart zueinander beabstandet angeordnet, das zwischen einer Wandfläche 8 der ersten Kammer 7. und einer gegenüberliegenden Wandfläche 10 der zweiten Kammer 9 ein Lüftungskanal 15 definiert wird. Der Lüftungskanal 15 ist über eine Eintrittsöffnung 17 sowie über eine Austrittsöffnung 19, die jeweils in dem Gehäuse 2 ausgebildet sind, mit dem Außenbereich verbunden. Die Eintritts- bzw. Austrittsöffnungen 17 und 19 können sich seitlich oder an der Ober- und Unterseite des Gehäuses 2 befinden.

Die den Lüftungskanal 15 definierenden Wandflächen 8, 10 weisen in der dargestellten bevorzugten Ausführungsform der vorliegenden Erfindung jeweils einen Kühlkörper 21, 23 auf. Dabei erstreckt sich der erste Kühlkörper 21 über nahezu die gesamte dem Lüftungskanal 15 zugewandte Wandfläche 8 des ersten Gehäuseabschnitts 3. Der zweite Kühlkörper 23 ist im oberen Bereich der Wandfläche 10 des zweiten Gehäuseabschnitts 5 angeordnet und von der Fläche her wesentlich kleiner als der erste Kühlkörper 21.

Eine wesentliche Eigenschaft der Kühlkörper 21, 23 ist ihre Wärmeleitfähigkeit. Sie sind deshalb aus einem sehr gut Wärme leitenden Material ausgebildet, beispielsweise einer Aluminiumgusslegierung. Darüber hinaus ist für eine optimale Wärmetauschfunktion erforderlich, dass die Kühlkörper 21, 23 eine möglichst große Fläche aufweisen. Dies wird in der bevorzugten Ausführungsform der vorliegenden Erfindung durch eine Vielzahl von Kühlrippen erreicht, die so ausgebildet sind, dass sie in Richtung der entsprechenden Luftströme geneigt sind. Dies hat den besonderen Vorteil, dass die durch die Kühlrippen entstehenden Luftverwirbelungen in der hier geschilderten Form relativ groß sind und deshalb für eine Zirkulation der Luftströme im Bereich der Kühlrippen sorgen, ohne den Luftstrom zu stark zu bremsen. Durch die besondere Form und Neigung der Kühlrippen wird folglich die Wärmeableitung erhöht. Selbstverständlich sind auch andere Formen von Kühlkörpern und Kühlrippen möglich.

Wie aus Fig. 1 ersichtlich, ist ebenfalls in dem ersten geschlossenen Gehäuseabschnitt 3 ein Lüfter 25, z.B. ein Walzenlüfter, angeordnet. Der Lüfter 25 erzeugt einen Luftstrom innerhalb der Kammer 7 entlang des ersten Kühlkörpers 21. In ähnlicher Weise erzeugt der Lüfter 27, der in der Kammer 9 angeordnet ist und als Axiallüfter ausgebildet ist, einen Luftstrom, der innerhalb der Kammer 9 am zweiten Kühlkörper 23 vorbei zirkuliert. In der in Fig. 1 gezeigten Ausführungsform ist der Lüfter 27 innerhalb des Gehäuses der Steuereinheit 13 angeordnet. Der zirkulierende Luftstrom innerhalb der zweiten Kammer 9 ist durch gestrichelte Pfeile gekennzeichnet. Er verläuft durch das Gehäuse der Steuereinheit 13 durch eine Öffnung in dem Gehäuse der Steuereinheit 13 am Kühlkörper 23 entlang, anschließend in den Zwischenraum zwischen der Außenwandfläche des zweiten Gehäuseabschnittes 5 und dem Gehäuse des Steuereinheit 13, um über geeignete Öffnungen wieder in das Gehäuse der Steuereinheit 13 einzutreten.

In dem Lüftungskanal 15 ist an einer Seite ein Lüfter 29 vorhanden, der z.B. ebenfalls als Walzenlüfter ausgebildet ist. Er ist dazu eingerichtet, die Umgebungsluft außerhalb des Gehäuses 2 über die Eintrittsöffnungen 17 einzusaugen und dem Luftstrom im Lüftungskanal 15 eine solche Richtung und Fließgeschwindigkeit zu geben, dass er bei der Austrittsöffnung 19 wieder aus dem Gehäuse 2 austritt.

In der Kammer 7 ist neben dem LCD-Panel 11 und dem Lüfter 25 auch eine Platte 31 schräg zum ersten Kühlkörper 21 und damit der Wandfläche 8 der Kammer 7 angeordnet. Dadurch wird ein sich verjüngender Kammerabschnitt 33 definiert, durch den der durch das LCD-Panel 11 erwärmte Luftstrom von dem Lüfter 25 gelenkt strömt. Durch die sich verjüngende Form des Kammerabschnitts 33 wird der Luftstrom durch den Venturi-Effekt in Richtung des enger werdenden Endes beschleunigt, obwohl die gewünschten Verwirbelungen an den Kühlrippen des ersten Kühlkörpers 21 dem zu einem gewissen Maße entgegenwirken.

Eine durchsichtige Platte 35 bildet die Außenwandfläche des ersten Gehäuseabschnitts 3. Die durchsichtige Platte 35 ist vorzugsweise aus bruchsicherem Glas oder glasähnlichem Kunststoff wie beispielsweise Polymethylmethacrylat oder dergleichen ausgeführt, um die elektrischen oder elektronischen Geräte vor Zerstörung zu schützen. Das LCD-Panel ist innerhalb der Kammer 7 zusammen mit der Platte 31 und dem Lüfter 25 derart angeordnet, dass ein gleichmäßiger Luftstrom an den langen Seitenflächen des LCD-Panels entlang jeweils auf beiden Seiten entsteht. Dadurch wird die Wärme des LCD-Panels abtransportiert und mit Hilfe des Lüfters 25 in den sich verjüngenden Kammerabschnitt 33 gelenkt.

Im Folgenden wird die Wirkungsweise der Wärmetauschfunktion des erfindungsgemäßen Gehäuses 2 bzw. des Monitorsystems 1 beschrieben. In den beiden in sich geschlossenen Gehäuseabschnitten 3 und 5, die die Kammern 7 und 9 definieren, zirkulieren zwei unabhängige Warmluftströme. Der erste Warmluftstrom um das LCD-Panel 11 herum nimmt die Verlustleistung des LCD-Panels 11 auf, die je nach Größe des Panels 11 ca. 100-500 W beträgt. Die Verlustleistung des PCs 13 im zweiten Gehäuseabschnitt 5 einschließlich der Stromversorgung des Bildschirms ist dagegen erheblich geringer, in einem Bereich von zwischen 50 und 100 W. Deshalb ist auch die Fläche des zweiten Kühlkörpers 23 im Vergleich zur Fläche des ersten Kühlkörpers 21 wesentlich kleiner. Die beiden in den jeweiligen Kammern 7 und 9 zirkulierenden Luftströme geben ihre Wärme jeweils an die Kühlkörper 21 bzw. 23 ab. Der durch den Lüfter 29 beschleunigte Kühlluftstrom im Lüftungskanal 15, der in Fig. 1 durch gepunktete Pfeile gekennzeichnet ist, nimmt die von den beiden Kühlkörpern 21 und 23 nach innen transportierte Wärme über die innen liegenden Kühlrippen auf, erwärmt sich dabei entsprechend und tritt dort aus dem Gehäuse 2 wieder aus.

Sämtliche Lüfter 25, 27, 29 sind temperaturgeregelt und ihre Förderleistung hängt damit von den zu transportierenden Wärmeluftströmen ab, die in den Kanälen bzw. Kammern verlaufen. Die als Walzenlüfter ausgebildeten Lüfter haben einen Durchsatz von bis zu 3.000 m³/h.

Die Platte 31, die zwischen dem ersten Kühlkörper 21 und der Rückseite des LCD-Panels 11 angeordnet ist, hat auch noch folgenden Effekt: Da die Monitoranordnung auch bei sehr niedrigen Temperaturen, bis zu -35°C, störungsfrei funktionieren soll, muss verhindert werden, dass das großflächige LCD-Panel 11 beschlägt. Durch die Platte 31 wird u.a. dafür gesorgt, dass der Luftstrom um das LCD-Panel 11 herum möglichst gleichmäßig ist. Um bei sehr niedrigen Temperaturen ein Einfrieren zu verhindern, kann die Steuereinrichtung 13 dazu eingerichtet sein, beispielsweise nur die Hintergrundbeleuchtung des Panels 11 anzusteuern.

Durch die Steuerung der Luftströme über Lüfter bei der bevorzugten Ausführungsform der vorliegenden Erfindung ist es möglich, dass die erfindungsgemäße Monitoranordnung 1 beliebig im Raum angeordnet werden kann und vollständig drehbar gelagert sein kann. Es ist ebenfalls möglich, auf beiden Seiten der Monitoranordnung 1 jeweils ein LCD-Panel 11 anzuordnen, wobei zu beachten ist, dass der zweite Kühlkörper 23 dann in entsprechender Größe gewählt sein muss, um die größere Verlustleistung des zweiten Panels zu kompensieren. Darüber hinaus ist es auch möglich, statt eines handelsüblichen PCs 13 eine Steuereinheit zu verwenden, die von einem kleinen, tragbaren Computer stammt. Damit lässt sich Platz sparen und die abzuführende Wärmeleistung der Steuereinheit 13 auf weniger als 20 W absenken, weshalb man gegebenenfalls auch vollständig auf den zweiten Kühlkörper 23 verzichten kann.

Es ist anzumerken, dass das Netzteil des LCD-Panels 11 in der bevorzugten Ausführungsform der vorliegenden Erfindung in Fig. 1 nicht dargestellt ist. Es befindet sich neben der Steuereinheit 13 innerhalb des zweiten Gehäuseabschnitts 5. Wie bereits erwähnt, wird seine Verlustleistung ebenfalls über den in der zweiten Kammer 9 zirkulierenden Luftstrom zum zweiten Kühlkörper 23 geführt.

Damit wurde ein Monitorsystem geschaffen, das einfach aufgebaut ist, im Freien einsetzbar ist und bei dem aufgrund der Anordnung der Kühlkörper und des Lüftungskanals im Inneren des Gehäuses keinerlei Beeinträchtigung der Kühlwirkung von außen stattfinden kann.
Gleichzeitig ist es möglich, die gesamte entstehende Wärmeleistung über zwei voneinander getrennte Kreisläufe abzuführen.

## Patentansprüche

1. Gehäuse (2) mit zwei in sich geschlossenen Gehäuseabschnitten (3, 5), von denen jeder eine Kammer (7, 9) definiert, die zur Aufnahme von elektrischen oder elektronischen Geräten (11, 13) geeignet ist, wobei die Gehäuseabschnitte (3, 5) beabstandet zueinander angeordnet sind, sodass zwischen einer Wandfläche (8) des ersten Gehäuseabschnittes (3) und einer gegenüberliegenden Wandfläche (10) des zweiten Gehäuseabschnittes (5) ein Lüftungskanal (15) definiert wird, der über mindestens eine Eintrittsöffnung (17) zur Zuführung kühler Luft sowie mindestens eine Austrittsöffnung (19) zur Abgabe erwärmter Luft mit der Umgebung verbunden ist, wobei mindestens eine der den Lüftungskanal (15) definierenden Wandflächen (8, 10) einen Kühlkörper (21, 23) aus Wärme leitendem Material aufweist.

2. Gehäuse (2) nach Anspruch 1, **dadurch gekennzeichnet, dass** in beiden Wandflächen (8, 10) jeweils mindestens ein Kühlkörper (21, 23) angeordnet ist.

3. Gehäuse (2) nach Anspruch 1 oder 2, **dadurch gekennzeichnet, dass** in der ersten und/oder zweiten Kammer (7, 9) ein Lüfter (25, 27) angeordnet ist, der geeignet ist, einen zirkulierenden Luftstrom innerhalb der Kammer (7, 9) zu erzeugen.

4. Gehäuse (2) nach einem der vorhergehenden Ansprüche, **dadurch gekennzeichnet, dass** in dem Lüftungskanal (15) mindestens ein Lüfter (29) angeordnet ist, der geeignet ist, einen Luftstrom von der Eintrittsöffnung (17) in Richtung der Austrittsöffnung (19) zu lenken.

5. Gehäuse (2) nach Anspruch 3 oder 4, **dadurch gekennzeichnet, dass** der oder jeder Lüfter (25, 27, 29) als Walzenlüfter ausgebildet ist.

6. Gehäuse (2) nach einem der Ansprüche 3 bis 5, **dadurch gekennzeichnet, dass** der oder jeder Lüfter (25, 27, 29) temperaturgeregelt ist.

7. Gehäuse (2) nach einem der vorhergehenden Ansprüche, **dadurch gekennzeichnet, dass** der oder jeder Kühlkörper (21, 23) eine Mehrzahl von Kühlrippen aufweist, die in Richtung des jeweiligen Luftstroms geneigt sind.

8. Gehäuse (2) nach einem der vorhergehenden Ansprüche, **dadurch gekennzeichnet, dass** der oder jeder Kühlkörper (21, 23) als Formteil aus einer gepressten Aluminiumlegierung ausgebildet ist.

9. Gehäuse (2) nach einem der vorhergehenden Ansprüche, **dadurch gekennzeichnet, dass** in der ersten Kammer (7) eine Platte (31) schräg zu der Wandfläche (8), die den Kühlkörper (21) aufweist, angeordnet ist, sodass zwischen der Platte (31) und der Wandfläche (8) ein sich in Richtung des Luftstroms verjüngender Kammerabschnitt (33) definiert wird.

10. Gehäuse (2) nach einem der vorhergehenden Ansprüche, **dadurch gekennzeichnet, dass** mindestens eine Außenfläche des Gehäuses (2) als durchsichtige Platte (35) ausgebildet ist.

11. Monitorsystem (1) für den Outdoor-Bereich, mit einem Gehäuse (2) nach einem der Ansprüche 1 bis 10, wobei das Monitorsystem in der ersten Kammer (7) einen Flachbildschirm (11) sowie in der zweiten Kammer (9) eine Steuereinheit (13) aufweist.

12. Monitorsystem (1) für den Outdoor-Bereich nach Anspruch 11, wobei der Flachbildschirm (11) in der ersten Kammer (7) derart angeordnet ist, dass zu beiden Seiten des Flachbildschirms jeweils ein Hohlraum ausgebildet ist.

13. Monitorsystem (1) für den Outdoor-Bereich nach Anspruch 11 oder 12, wobei in der zweiten Kammer (9) ein Computer mit integriertem Lüfter (27) angeordnet ist, der eine Luftzirkulation in der zweiten Kammer (9) hervorruft.
